(19) **Europäisches Patentamt / European Patent Office / Office européen des brevets**

(11) **EP 3 481 163 A1**

(12) # EUROPEAN PATENT APPLICATION
published in accordance with Art. 153(4) EPC

(43) Date of publication:
**08.05.2019 Bulletin 2019/19**

(21) Application number: **16908905.9**

(22) Date of filing: **02.12.2016**

(51) Int Cl.:
*H05K 3/20* (2006.01)          *H01L 23/50* (2006.01)
*H05K 1/02* (2006.01)          *H05K 3/28* (2006.01)

(86) International application number:
**PCT/JP2016/085937**

(87) International publication number:
**WO 2018/012006 (18.01.2018 Gazette 2018/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **12.07.2016 JP 2016137462**

(71) Applicant: **Hitachi Chemical Company, Ltd.**
**Chiyoda-ku**
**Tokyo 100-6606 (JP)**

(72) Inventors:
• **NISHIYAMA, Tomoo**
  **Tokyo 100-6606 (JP)**
• **TOGAWA, Mitsuo**
  **Tokyo 100-6606 (JP)**

• **YASU, Katsuhiko**
  **Tokyo 100-6606 (JP)**
• **TAKEZAWA, Yoshitaka**
  **Tokyo 100-6606 (JP)**
• **MIYAZAKI, Yasuo**
  **Tokyo 100-6606 (JP)**
• **HARA, Naoki**
  **Tokyo 100-6606 (JP)**
• **HIRABAYASHI, Mitsunobu**
  **Tokyo 100-6606 (JP)**
• **AMANUMA, Shinji**
  **Tokyo 100-6606 (JP)**
• **HAYAKAZE, Takuya**
  **Tokyo 100-6606 (JP)**

(74) Representative: **Hoffmann Eitle**
**Patent- und Rechtsanwälte PartmbB**
**Arabellastraße 30**
**81925 München (DE)**

(54) **CIRCUIT BOARD MANUFACTURING METHOD AND CIRCUIT BOARD**

(57)     A method of producing a circuit board includes: a step of removing a temporary substrate from a circuit that is formed on the temporary substrate, and a step of disposing the circuit on an insulating layer, in such a manner that a side of the circuit that faced the temporary substrate faces the insulating layer.

FIG. 7

## Description

Technical Field

The present invention relates to a method of producing a circuit board, and to a circuit board.

Background Art

Along with the progress of downsizing and development of higher functionality of electronic equipment, printed circuit boards are widely used as circuit boards capable of mounting electronic components at a high density. Generally, a printed circuit board is produced by bonding a metal foil to a substrate, and etching it to process the same into a desired circuit shape.

On the other hand, with the diversification of the use environment of electronic devices, an increase in the current carrying capacity of a circuit board (realization of enlargement of current) has been required. The current carrying capacity of a circuit board may be increased by increasing the cross-sectional area of the circuit. However, it is technically difficult to increase the thickness of a circuit in a case in which the circuit is formed by etching in a printed circuit board (for example, the circuit becomes trapezoidal and it becomes difficult to secure insulation between the circuits). Further, when the thickness of a circuit is increased, the immersion time in an etchant is required to be longer, which may adversely affect the quality. Therefore, in order to increase the cross-sectional area of a circuit formed by etching, it is necessary to widen the width of the wiring rather than increasing the thickness of the same. As a result, it may not be possible to respond to the demand for downsizing a circuit board.

As a method of realizing enlargement of current while responding to the downsizing of a circuit board, a method of embedding a metallic component, in which a circuit has been previously formed, in an insulating layer containing a resin has been proposed (see, for example, Patent Document 1).

Citation List

Patent Document

[Patent Document 1] Japanese Patent Application Laid-Open (JP-A) No. 2001-36201

SUMMARY OF INVENTION

Technical Problem

According to the method described in Patent Document 1, a circuit board is produced by forcing a metallic member into an insulating layer softened by heat. However, in this method, voids may be generated at the interface between the metallic member and the insulating layer when the metallic member is forced into the resin substrate, the position of the metallic component may be shifted, or the displaced resin may bulge out to change the dimensions. As a result, it is likely that insulation reliability is deteriorated.

In view of the above circumstances, an object of the present invention is to provide a method of producing a circuit board which is capable of producing a circuit board which has a large current carrying capacity and has superior insulation reliability; and to provide a circuit board which has a large current carrying capacity and has superior insulation reliability.

Solution to Problem

Specific means for approaching the above objects include the following embodiments.

<1> A method of producing a circuit board, including:

a step of removing a temporary substrate from a circuit that is formed on the temporary substrate; and
a step of disposing the circuit on an insulating layer, in such a manner that a side of the circuit that faced the temporary substrate faces the insulating layer.

<2> The method of producing a circuit board according to <1> above, wherein the circuit is formed by removing a bridge from a metallic member that is disposed on the temporary substrate and that has a circuit portion and the bridge.
<3> The method of producing a circuit board according to <1> or <2> above, further including a step of filling, with a resin, a space between circuits formed on the temporary substrate.

<4> The method of producing a circuit board according to <1> to <3> above, wherein a thickness of the circuit is 350 $\mu$m or greater.

<5> The method of producing a circuit board according to any one of <1> to <4> above, wherein a thickness of the insulating layer is smaller than a thickness of the circuit.

<6> A circuit board, including:

an insulating layer; and
a circuit disposed on the insulating layer,
wherein a thickness of the circuit is 350 $\mu$m or greater.

<7> The circuit board according to <6> above, further including a resin with which a space between circuits is filed.

<8> The circuit board according to <6> or <7> above, wherein a thickness of the insulating layer is less than a thickness of the circuit.

Advantageous Effects of Invention

According to the invention, a method of producing a circuit board is provided, which is capable of producing a circuit board that has a large current carrying capacity and that has superior insulation reliability; as well as a circuit board which has a large current carrying capacity and has superior insulation reliability is provided.

BRIEF DESCRIPTION OF DRAWINGS

Figure 1 is a perspective view conceptually showing a state in which a metallic member having a circuit portion and a bridge is disposed on a temporary substrate.
Figure 2 is a cross-sectional view conceptually showing a state in which a metallic member having a circuit portion and a bridge is disposed on a temporary substrate.
Figure 3 is a perspective view conceptually showing a state after a bridge has been removed from a metallic component.
Figure 4 is a cross-sectional view conceptually showing a state after a bridge has been removed from a metallic member.
Figure 5 is a perspective view conceptually showing a state in which a space between circuits is filled with a resin.
Figure 6 is a cross-sectional view conceptually showing a state in which a space between circuits circuit is filled with a resin.
Figure 7 is a perspective view conceptually showing a state in which a circuit is disposed on an insulating layer.
Figure 8 is a cross sectional view conceptually showing a state in which a circuit is disposed on an insulating layer.
Figure 9 is a perspective view conceptually showing a (conventional) circuit board having a circuit formed by etching.
Figure 10 is a cross sectional view conceptually showing a (conventional) circuit board having a circuit formed by etching.

DESCRIPTION OF EMBODIMENTS

Embodiments for carrying out the invention will be described below in detail. However, the invention is not limited to the following embodiments. In the following embodiments, each constituent element (including an elemental step or the like) is not mandatory unless otherwise stated. The same applies to numerical values or ranges thereof, which do not limit the invention.

The term "step" as used herein includes not only an independent step, but also a step which may not be clearly separated from another step, insofar as an intended function of the step can be be attained.

A numerical range expressed by "x to y" or "between x and y" includes herein the values of x and y in the range as the minimum and maximum values, respectively.

In a numerical range described herein in stages, the upper or lower limit of the numerical range of one stage may be replaced with the upper limit value or the lower limit of the numerical range of the other stages. Further, in a numerical range given herein, the upper or lower limit of the numerical range may be replaced with a relevant value shown in an Example.

Further, the term "layer" comprehends herein not only a structure formed over the whole observed region including the layer, but also a structure formed only on a part of the region.

<Method of Producing Circuit Board>

A method of producing a circuit board according to an embodiment of the invention includes: a step of removing a temporary substrate from a circuit that is formed on the temporary substrate; and a step of disposing the circuit on an insulating layer, in such manner that a side of the circuit that faced the temporary substrate faces the insulating layer.

In an embodiment, the thickness of the circuit formed on the insulating layer is 350 $\mu$m or greater. In an embodiment, the thickness of the insulating layer is less than the thickness of the circuit. In an embodiment, the ratio A/B of the thickness of the insulating layer A to the thickness of the circuit B may be 0.8 or less, or may be 0.5 or less.

In the production method according to the present embodiment, a temporary substrate is removed from a circuit that has been formed on the temporary substrate, and the circuit is disposed on an insulating layer in such a manner that the side of the circuit that faced the temporary substrate faces the insulating layer, whereby the circuit is formed on an insulating layer. Therefore, the risk of occurrence of voids at the interface between the circuit and the insulating layer, which is caused by forcing the circuit into the insulating layer, is prevented. Further, the risk that the position of the circuit is shifted by forcing the circuit into the insulating layer to deteriorate the dimensional stability is prevented. As a result, it is possible to produce a circuit board having superior insulation reliability.

According to the production method of the present embodiment, the circuit is formed by using a circuit previously formed on a temporary substrate. Therefore, it is possible to form a circuit which is thicker than a case in which a circuit is formed by etching on an insulating layer. Consequently, it is possible to increase the cross-sectional area of a circuit without increasing the width of the circuit, and to realize the enlargement of current while dealing with downsizing of the circuit board. Further, by forming a circuit having a larger thickness, the circuit enables the promotion of thermal diffusion in the surface direction, whereby the effect of suppressing temperature rise of the circuit board may also be expected.

Herein, a state in which a circuit is "disposed" on an insulating layer encompasses both of a case in which the circuit is not embedded in the insulating layer at all (i.e., the embedment depth is 0 $\mu$m), and a case in which the embedment depth of the circuit in the insulating layer is 20 $\mu$m or less.

The "embedment depth" of a circuit as used herein means the distance between the upper surface of the insulating layer (i.e., the surface facing the circuit in a state before deformation due to embedment of the circuit) and the lower surface of the circuit (i.e., the surface facing the insulating layer in a state after the embedment). More specifically, it may be a value calculated as (A + B - C) obtained by subtracting the thickness C of a circuit board at a region in which a circuit has been formed after the disposing of the circuit on an insulating layer from the sum of the thickness A of the circuit before the disposing of the circuit on the insulating layer and the thickness B of the insulating layer, or may be a value obtained by observing the cross section of the circuit board and measuring the embedment depth.

In a case in which the embedment depth in the circuit board is not uniform, the average value of the embedment depths measured at five places is regarded as the "embedment depth". When the embedment depth of the circuit exceeds 20 $\mu$m, it is also herein referred to as "embedded".

In the production method according to the present embodiment, there is no particular restriction on the method of removing a temporary substrate from a circuit formed on the temporary substrate. For example, a sheet having flexibility may be used as a temporary substrate, and this may be peeled off from a circuit.

In the production method according to the present embodiment, there is no particular restriction on the method of disposing a circuit from which the temporary substrate has been removed on an insulating layer. For example, the circuit may be disposed on the insulating layer in the gravity direction, or the insulating layer may be disposed on the circuit in the gravity direction, or another method may be applied.

From the viewpoint of enhancing the adhesion between the circuit and the insulating layer, it is preferable to perform at least one of heating or pressurization, when the circuit is disposed on the insulating layer. When heating is carried out during the disposing of the circuit on the insulating layer, there is no particular restriction on the heating temperature. For example, it may be selected from the range of from 50°C to 250°C. When pressurization is carried during the disposing of the circuit on the insulating layer, there is no particular restriction on the pressure. For example, it may be selected from the range of from 0.1 MPa to 50 MPa.

(Insulating Layer)

An insulating layer used in the production method of the present embodiment may contain a resin. There is no particular restriction on a resin to be contained in the insulating layer, and examples thereof include thermosetting resins such as an epoxy resin, a phenol resin, a urea resin, a melamine resin, a urethane resin, a silicone resin, an unsaturated polyester resin, or an acrylic resin. The resin contained in the insulating layer may be one kind or two or more kinds. From the viewpoints of electrical insulation and adhesion to a circuit, it is preferable that the insulating layer contains at least one selected from the group consisting of an epoxy resin, a silicone resin, and a urethane resin. The insulating layer may contain, if necessary, a component other than a resin, such as a filler.

There is no particular restriction on the thickness of an insulating layer, and it may be selected in accordance with the use of a circuit board, etc. From a viewpoint of ensuring satisfactory insulation performance, the thickness of an insulating layer is preferably 60 $\mu$m or greater, more preferably 90 $\mu$m or greater, and further preferably 120 $\mu$m or greater.

From a viewpoint of ensuring satisfactory heat dissipation performance, a smaller thickness of the insulating layer is more preferable. For example, it is preferably 230 $\mu$m or less, more preferably 210 $\mu$m or less, and further preferably 190 $\mu$m or less.

The insulating layer may be formed from an independent member (such as a resin sheet), or may be formed by applying a material for an insulating layer onto a base plate to be disposed under the circuit board. When an insulating layer is formed from an independent member, it is easy to manufacture a circuit board with a large area, which tends to be advantageous in terms of productivity. On the other hand, when an insulating layer is formed on a base plate, the adhesion between the base plate and the insulating layer tends to be improved. There are no particular restrictions on the method of applying a material for an insulating layer onto a base plate, and examples thereof include a dispensing method, a spraying method, and a printing method, such as a gravure method or a screen printing.

From a viewpoint of enhancing the adhesion between a circuit and an insulating layer, while suppressing the embedment of the circuit into the insulating layer, the insulating layer is preferably in the B stage when the circuit is to be disposed. More specifically, a thermosetting resin contained in the insulating layer is preferably in a semi-cured stage. In this regard, the B stage as used herein means a state in which the viscosity of an insulating layer is from $10^4$ Pa·s to $10^9$ Pa·s at room temperature (25°C), and is from $10^2$ Pa·s to $10^7$ Pa·s at 100°C, and the viscosity at 100°C is lower by from 0.001% to 50% as compared to the viscosity at room temperature (25°C). In addition, an insulating layer after curing does not melt even by heating. The above viscosity may be measured by a dynamic viscoelasticity measurement (frequency: 1 Hz, load: 40 g, rate of temperature increase: 3°C/min).

(Circuit)

In the production method according to the present embodiment, there is no particular restriction on the thickness of a circuit disposed on an insulating layer, and it may be selected according to the use of a circuit board of the like. From the viewpoint of realization of the enlargement of current of the circuit board, the thickness of a circuit is preferably 350 $\mu$m or greater, more preferably 400 $\mu$m or greater, and further preferably 500 $\mu$m or greater. From a viewpoint of the capacity of the circuit board itself, the thickness of a circuit is preferably 5,000 $\mu$m or less. The thickness of a circuit as used herein means the thickness of the circuit itself, and when the the circuit is embedded in an insulating layer, the thickness of the embedded portion is also included in the the thickness of the circuit.

There is no particular restriction on the width and the length of a circuit in a circuit board, and these may be selected in accordance with the use of the circuit board or the like. For example, the width and length may be selected from the range of from 350 $\mu$m to 20,000 $\mu$m.

There is no particular restriction on the material of a circuit. Examples thereof include copper, silver, chromium copper, tungsten copper, nickel, nickel plated copper, aluminum, and aluminum which is surface-modified with alumite.

It is preferable that the surface of a circuit at a side that contacts the insulating layer is in a state in which generation of voids is reduced and satisfactory adhesion with the insulating layer is achieved. In order to improve environmental resistance in terms of temperature, humidity, etc., ruggedness serving as anchors may be formed on the surface of the circuit that contacts the insulating layer by a roughening treatment or the like. There is no particular restriction on a roughening treatment method, and it may be performed by a physical method or a chemical method. Examples of the physical method include filing, sand blasting, and laser irradiation. Examples of the chemical method include a MacDermid treatment, a CZ treatment, a blackening treatment, and an etching treatment. The roughening treatment may be carried out by any one of the methods, or may be carried out by a combination of a physical method and a chemical method, a combination of chemical methods, or a combination of physical methods.

It is preferable that a circuit which is not yet disposed on an insulating layer is a circuit that has been formed on a temporary substrate by disposing a metallic member having a circuit portion and a bridge on a temporary substrate, followed by removing the bridge from the metallic member. The circuit portion of the metallic member is a portion to constitute a circuit of a circuit board. The bridge is a portion that connects the circuit portions together, or a circuit portion and an outer frame for fixing the positions of the circuit portions in the metallic member, and is removed after the disposing of the metallic member on a temporary substrate.

There is no particular restriction on a method of forming a circuit portion and a bridge in a metallic member. For example, it can be carried out by cutting, etching, punching, buffing, or the like. From a viewpoint of removing a bridge after disposing a metallic member on a temporary substrate while leaving a circuit portion, the thickness of a bridge is preferably smaller than the thickness of a circuit portion.

There is no particular restriction on a method of removing a bridge from a metallic member after the metallic member has been disposed on a temporary substrate. For example, it can be carried out by punching, cutting, etching, laser cutting, or the like.

The production method according to the present embodiment may further include a step of filling, with a resin, a space between circuits that have been formed on a temporary substrate. By filling the space between circuits with a resin, the moisture resistance reliability of a circuit board tends to be satisfactory secured, and the occurrence of surface creepage, partial discharge, tracking, migration, or the like tends to be suppressed. Further, it is believed to be possible that the space between circuits can be filled adequately with the resin and the insulation reliability is improved, even in a case of a circuit pattern having a complicated shape, as compared to the method in which a circuit is forced into an insulating layer.

There is no particular restriction on a resin used for filling. Examples thereof include thermosetting resins such as an epoxy resin, a phenol resin, a urea resin, a melamine resin, a urethane resin, a silicone resin, an unsaturated polyester resin, or an acrylic resin. The resin used for filling may be composed of one kind or may be composed of two or more kinds. From the viewpoints of electrical insulation and adhesiveness, it is preferable that the resin used for filling contains at least one selected from the group consisting of an epoxy resin, a silicone resin, and a urethane resin. The resin used for filling may optionally contain a component other than the resin, such as a filler.

There is no particular restriction on a method of filling a space between circuits with a resin. For example, it can be carried out by a molding method using a powdery resin material, a casting method or a coating method using a liquid resin, a method in which a solid resin is melted and injected into a gap, such as a pressing method or an extrusion method, or the like.

The amount of a resin to be applied for filling a space between circuits may be such that the height of the resin filling the space is the same as or lower than the height of the circuit, or even exceeds the height of the circuit.

In a case in which the height of the resin filling the space is lower than the height of the circuit, it is preferable to carry out pressurization when a circuit is disposed on an insulating layer so that generation of a void is inhibited in the resin which has filled the space.

From the viewpoint of uniformly applying the pressure during the disposing of a circuit on an insulating layer to inhibit the generation of a region with insufficient insulation, the amount of the resin filling the space is preferably such that the height of the resin filling the space is the same as the height of the circuit, or slightly lower than the height of the circuit with an allowance for deformation of the resin.

The production method according to the present embodiment may optionally include a step(s) other than the above-described steps. For example, the production method may include a step of curing the thermosetting resin, a step of providing an additional layer for the purpose of insulation, etc. on a circuit that has been formed on an insulating layer, a step of cutting a manufactured circuit board into a desired shape, or the like.

<Circuit Board>

The circuit board according to an embodiment of the invention has: an insulating layer containing a resin; and a circuit disposed on the insulating layer, in which the thickness of the circuit is 350 $\mu$m or greater.

The circuit board according to the present embodiment has superior insulation reliability as compared with a circuit board in which a circuit is embedded in an insulating layer. Although the reason for the above is not clear, it is presumed that there is less possibility of generation of voids at the interface between the circuit and the insulating layer as compared with the case in which the circuit is forced into the insulating layer, and there is less possibility of shift of the position of the circuit as compared with the case in which the circuit is forced into the insulating layer so as to secure excellent dimensional stability, etc.

Further, in the circuit board according to the present embodiment, the thickness of a circuit is 350 $\mu$m or greater. For this reason, the cross-sectional area can be made larger without increasing the width of the circuit as compared with a circuit board having a circuit formed by etching on an insulating layer, so that enlargement of current can be realized, while dealing with downsizing of the circuit board. Further, by forming a circuit having a larger thickness, the circuit is able to promote thermal diffusion to the surface direction, so that the effect of suppressing the temperature rise of the circuit board may also be expected.

In an embodiment, the thickness of an insulating layer of a circuit board is smaller than the thickness of a circuit.

The details and preferred embodiments of an insulating layer and a circuit used for a circuit board according to the present embodiment are the same as the details and preferred embodiments of an insulating layer and a circuit used in the afore-described method of producing a circuit board.

A state in which a circuit is "disposed" on an insulating layer as used herein encompasses both a case in which the circuit is not embedded in the insulating layer at all (i.e., the embedment depth is 0 $\mu$m), and a case in which the embedment depth of the circuit in the insulating layer is 20 $\mu$m or less.

The "embedment depth" of a circuit as used herein means the distance between the upper surface of the insulating layer (i.e., the surface facing the circuit in a state before deformation due to embedment of the circuit) and the lower surface of the circuit (i.e., the surface facing the insulating layer in a state after the embedment). More specifically, it may be a value calculated as (A + B - C) obtained by subtracting the thickness C of a circuit board at a region in which a circuit has been formed after the disposing of the circuit on an insulating layer from the sum of the thickness A of the circuit before the disposing of the circuit on the insulating layer and the thickness B of the insulating layer, or may be a value obtained by observing the cross section of the circuit board and measuring the embedment depth.

In a case in which the embedment depth in the circuit board is not uniform, the average value of the embedment depths measured at five places is regarded as the "embedment depth".

In the circuit board according to the present embodiment, a space between circuits may be filled with a resin. The details and preferred embodiments of the resin used for filling are the same as the details and preferred embodiments of a resin used for filling a space between circuits in the afore-described method of producing a circuit board.

The circuit board according to the present embodiment may optionally have a member(s) other than a circuit, an insulating layer, and a resin that fills a space between circuits. For example, a member such as a base plate or a heat spreader may be disposed on the side of the insulating layer opposite to the side on which the circuit is disposed. There is no particular restriction on the material for the member, and examples thereof include copper, aluminum, a copper alloy such as tungsten copper or molybdenum copper, and nickel plated copper.

Specific examples of the method of producing a circuit board as well as the circuit board according to the present embodiments will be described below by referring to the drawings. However, the present embodiments are not limited thereto. In this regard, the dimensions of members in each drawing are conceptual, and relative dimensional relationships among the members are not limited thereto.

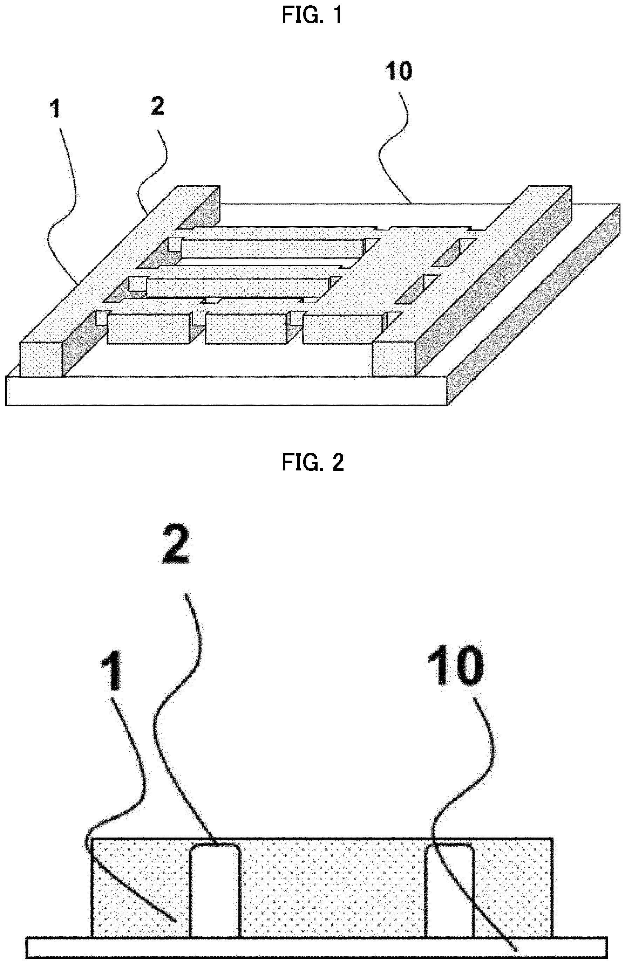

Figure 1 is a perspective view conceptually showing a state in which a metallic member having a circuit portion 1 and a bridge 2 is disposed on a temporary substrate 10, and Figure 2 is a cross-sectional view conceptually showing the state. As shown in Figure 1 and Figure 2, the bridge 2 connects the circuit portions 1 of the metallic member each other, or connects the circuit portion 1 with an outer frame of the metallic member. As a result, it is possible to easily dispose the metallic member on the temporary substrate 10. The thickness of the bridge 2 is smaller than the thickness of the circuit portion 1. As a result, it is possible to easily remove only the bridge 2 after the metallic member has been disposed on the temporary substrate 10.

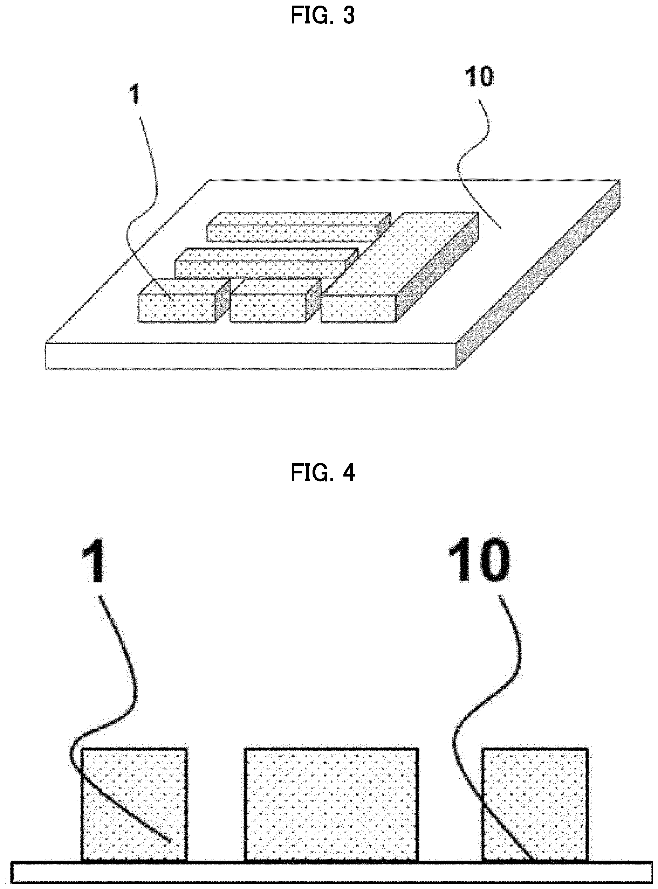

Figure 3 is a perspective view conceptually showing a state after removal of the bridge 2 from the metallic member, and Figure 4 is a cross-sectional view conceptually showing the state. As shown in Figure 3 and Figure 4, a state in which only the circuit portion 1 is disposed on the temporary substrate 10 is established by removing the bridge 2.

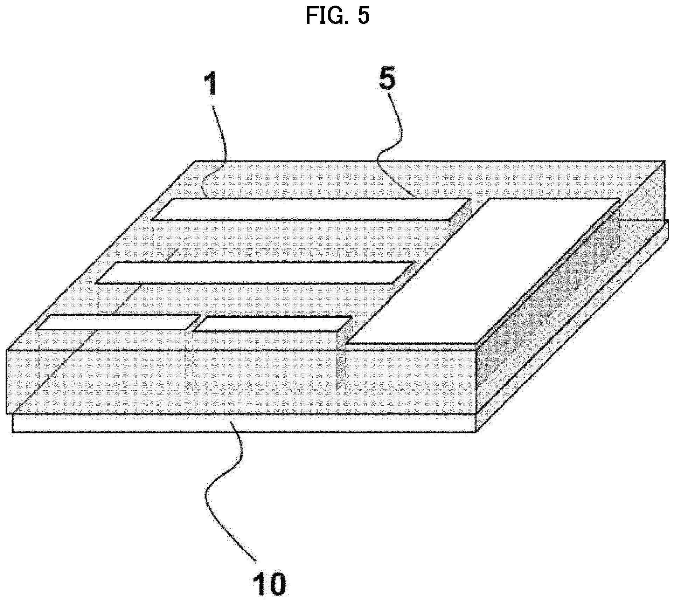

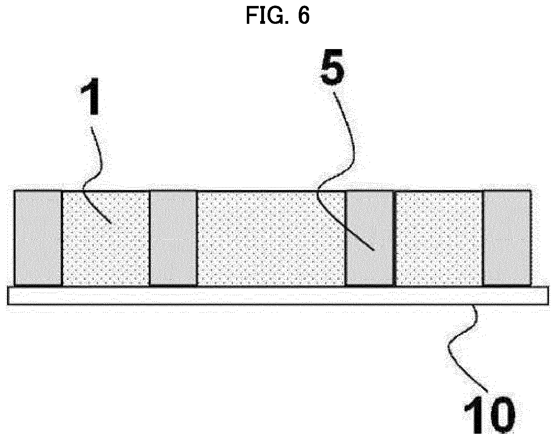

Figure 5 is a perspective view conceptually showing a state in which spaces between circuit portions 1 are filled with a resin 5, and Figure 6 is a cross sectional view conceptually showing the state.

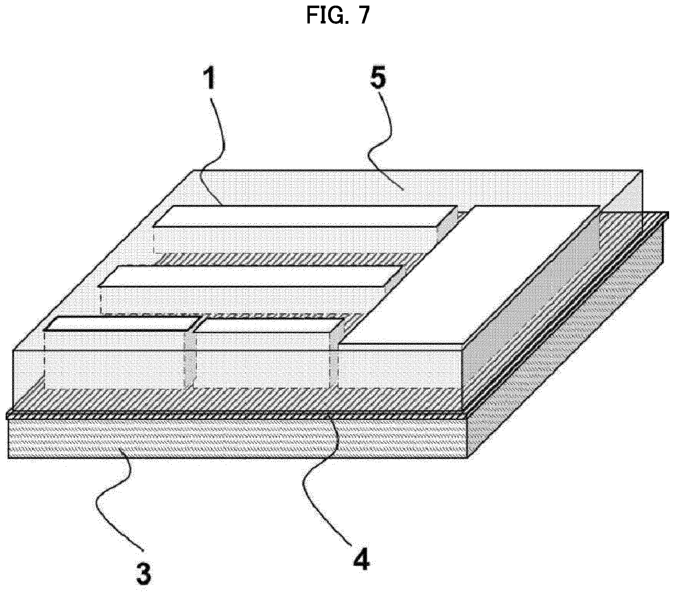

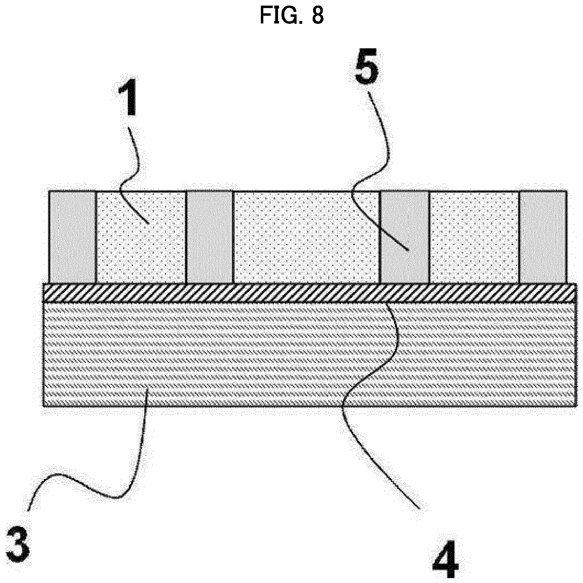

Figure 7 is a perspective view conceptually showing a state in which the circuit portion 1 from which the temporary substrate 10 has been removed is disposed on the insulating layer 4 together with the resin 5, and Figure 8 is a sectional view conceptually showing the state. In Figure 7 and Figure 8, a heat spreader 3 is disposed on the side of the insulating layer 4 opposite to the side on which the circuit portion 1 is disposed.

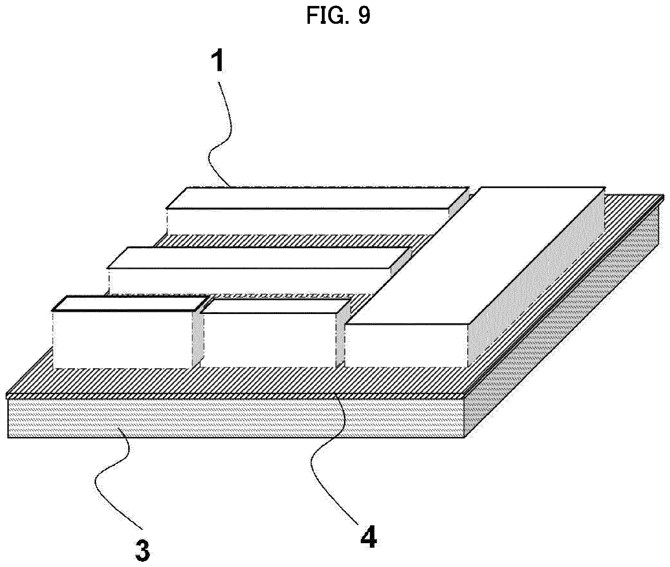

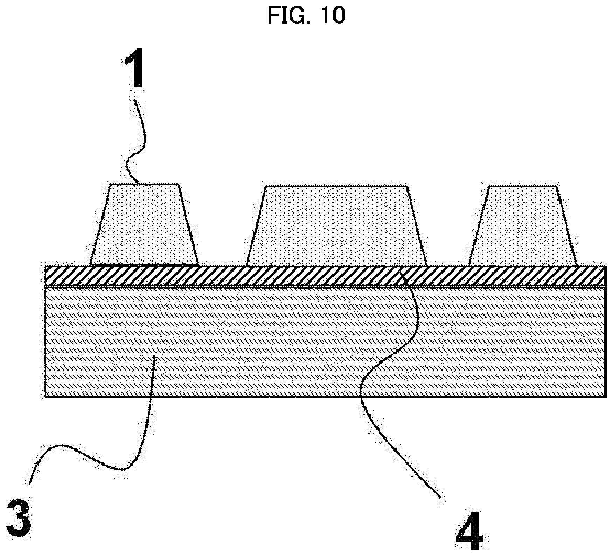

Figure 9 is a perspective view conceptually showing a (conventional) circuit board having a circuit 1 formed by etching, and Figure 10 is a cross sectional view conceptually showing the state. In a case in which a circuit is formed by etching, when the thickness of the circuit is increased, the formed circuit tends to become trapezoidal and the distance between the circuits becomes narrower to make maintenance of the insulating property difficult. In addition, for the reason that the quality may be deteriorated and the like if the immersion time in an etchant becomes longer, an acceptable thickness of the circuit is generally limited to about 200 μm. Accordingly, heretofore the width of a circuit has been widened to increase the current carrying capacity and to mitigate concentration of heat on a part, such as a chip or a capacitor, in the circuit. However, it is disadvantageous for downsizing a circuit board because the area occupied by the circuit increases.

EXAMPLES

Hereinbelow, the invention will be described in more detail by referring to Examples. However, the invention is not limited to the Examples.

<Example 1>

A metallic member having a circuit portion and a bridge was produced by cutting and punching a copper sheet having a thickness of 500 μm. The metallic member is disposed on a temporary substrate (PET film), the bridge was removed therefrom to form circuits, and the spaces between the circuits were filled with a resin (CEL-C-3900, available from Hitachi Chemical Co., Ltd.).

A protective PET film was peeled off from one side of a resin sheet that serves as an insulating layer (a B stage sheet using an epoxy resin composition, Grade number "HTX", available from Hitachi Chemical Co., Ltd., filler content: 85% by mass, thickness: 150 μm). Subsequently, the resin sheet was disposed on a copper sheet (thickness: 500 μm) that serves as a heat spreader in such a manner that the surface from which the protective PET film had been peeled off faced the copper sheet.

Subsequently, the temporary substrate was peeled from the circuits that had been formed on the temporary substrate, and the circuits were disposed on the resin sheet. The circuits were disposed in such a manner that the surface that had faced the temporary substrate faced the surface of the resin sheet from which the other protective PET film had been peeled off. The disposing of the circuits was performed by thermal compression bonding in a vacuum. Specifically, the press temperature was raised from the start temperature of 50°C to 180°C at a rate of 3°C/min, kept at 180°C for 2 hours, and then cooled down to 50°C while maintaining the pressure. Throughout this operation, namely from before the start of the temperature increase to the completion of cooling, the degree of vacuum was set at 1 kPa or less, and the press pressure was set at 10 MPa. In this way, a circuit board was produced.

<Example 2>

A circuit board was produced in the same manner as in Example 1 except that a metallic member produced using a copper sheet having a thickness of 1,000 μm was used instead of the copper sheet having a thickness of 500 μm, and that a copper sheet having a thickness of 1,000 μm was used as a heat spreader instead of the copper sheet having a thickness of 500 μm.

<Example 3>

A circuit board was produced in the same manner as in Example 1 except that a metallic member produced using a copper sheet having a thickness of 2,000 μm was used instead of the copper sheet having a thickness of 500 μm, and that a copper sheet having a thickness of 2,000 μm was used as a heat spreader instead of the copper sheet having a thickness of 500 μm.

<Examples 4 to 6>

Circuit boards were produced in the same manner as in Examples 1 to 3, respectively, except that the press pressure in the disposing of a circuit on an insulating layer was changed from 10 MPa to 30 MPa.

<Comparative Example 1>

A circuit was formed on a temporary substrate in the same manner as in Example 1 except that the space between the circuits was not filled with a resin. Next, a laminate obtained by stacking 6 resin sheets used in Example 1 was used as an insulating layer, and disposed on a copper sheet (thickness: 500 μm) that serves as a heat spreader. The circuit, from which the temporary substrate had been removed, was disposed on the insulating layer, and a spacer of 1,200 μm was placed thereon for securing the thickness of the insulating layer. The disposing of the circuit was performed by thermal compression bonding in a vacuum. Specifically, the press temperature was raised from the start temperature of 50°C to 180°C at a rate of 3°C/min, kept at 180°C for 2 hours, and then cooled down to 50°C while maintaining the pressure. Throughout this operation, namely from before the start of the temperature increase to the completion of cooling, the degree of vacuum was set at 1 kPa or less, and the press pressure was set at 15 MPa. In this way, a circuit board in which the circuit was embedded in the insulating layer was produced.

<Comparative Example 2>

A circuit board in a state in which a circuit was embedded in an insulating layer was produced in the same manner as in Comparative Example 1, except that a metallic member produced using a copper sheet having a thickness of 1,000 μm was used instead of the copper sheet having a thickness of 500 μm; a copper sheet having a thickness of 1,000 μm was used as the heat spreader instead of the copper sheet having a thickness of 500 μm; a laminate obtained by stacking 9 resin sheets was used as the insulating layer; and a spacer of 2,200 μm was used instead of the spacer of 1,200 μm.

<Comparative Example 3>

A circuit board in a state in which a circuit was embedded in an insulating layer was produced in the same manner as in Comparative Example 1, except that a metallic member produced using a copper sheet having a thickness of 2,000 μm was used instead of the copper sheet having a thickness of 500 μm; a copper sheet having a thickness of 2,000 μm was used as the heat spreader instead of the copper sheet having a thickness of 500 μm; a laminate obtained by stacking 16 resin sheets was used as the insulating layer; and a spacer of 4,200 μm was used instead of the spacer

of 1,200 $\mu$m.

(Measurement of Embedment Depth)

The embedment depth of a circuit (A + B - C) was calculated from the value C obtained by measuring quantitatively the thickness of a portion of the prepared circuit board, in which a circuit had been formed, using a coordinate measuring machine (Model: VR-3000 D, available from KEYENCE CORPORATION), the thickness A of a copper sheet used for producing the circuit, and the thickness B of an insulating layer. The results are shown in Table 1.

(Measurement of Breakdown Voltage)

The surface of a circuit board on the side on which a circuit had been formed and the surface of a heat spreader were respectively connected to electrodes. Then, the entire circuit board was dipped in FLUORINERT and the breakdown voltage was measured. As for measurement conditions, the measurement start voltage was set at 500 (V), and then the voltage was stepwise increased by 500 (V) and kept there for 30 sec, which step was repeated. When the current value exceeds 0.2 (mA), the then voltage was defined as a breakdown voltage. The results are shown in Table 1.

(Measurement of Thermal Resistance)

The produced circuit board was cut into a size of 10 mm $\times$ 10 mm to prepare a specimen for a thermal resistance measurement. The specimen was stuck to a thermal resistance tester (Model number YST-901S, available from YAMAYOSHIKENKI.COM) using a silicone grease (X-22-7868-2D, available from Shin-Etsu Chemical Co., Ltd.), and a load of 1 MPa was applied. Then, the temperature difference $\Delta$T between the upper and lower surfaces of the specimen was measured with an input power of 13 W, at the specimen temperature of 50°C, and the water temperature of 30°C. The thermal resistance was calculated according to the following equation:

$$\text{Thermal resistance (°C/W)} = \Delta T/\text{Input heat quantity - Apparatus constant}$$

(Evaluation of Position Shift)

Occurrence of position shift of a circuit in a circuit board was observed using an optical microscope. Specifically, in a case in which position shift of a circuit from the predetermined position by 50 $\mu$m or greater in the height direction of the circuit board was detected at an arbitrary region, it was rated as "fail", and in a case in which position shift of a circuit from the predetermined position by 50 $\mu$m or greater in the height direction of the circuit board was not detected at any region, it was rated as "pass".

Table 1

| | Example 1 | Example 2 | Example 3 | Example 4 | Example 5 | Example 6 | Comparative Example 1 | Comparative Example 2 | Comparative Example 3 |
|---|---|---|---|---|---|---|---|---|---|
| Embedment depth (μm) | 8 | 6 | 6 | 12 | 13 | 9 | 42 | 36 | 47 |
| Thickness of circuit (μm) | 500 | 1000 | 2000 | 500 | 1000 | 2000 | 500 | 1000 | 2000 |
| Thermal resistance (°C/W) | 0.22 | 0.20 | 0.17 | 0.22 | 0.20 | 0.17 | 0.58 | 0.43 | 0.41 |
| Breakdown voltage (kV) | >10 | >10 | >10 | >10 | >10 | >10 | 3.5 | 3.0 | 4.0 |
| Position shift | Pass | Pass | Pass | Pass | Pass | Pass | Fail | Fail | Fail |

As shown in Table 1, the thermal resistance and breakdown voltage of the circuit boards of Examples 1 to 6 in which a circuit was not embedded in an insulating layer, or the embedment depth into an insulating layer was 20 $\mu$m or less were lower than those of the circuit boards of Comparative Examples 1 to 3 in which the embedment depth into an insulating layer exceeded 20 $\mu$m. Further, the evaluation of the circuit position shift was also favorable.

Reference Signs List

1    Circuit portion
2    Bridge
3    Heat spreader
4    Insulating layer
5    Resin
6    Circuit
7    Resin
10   Temporary substrate


**Claims**

1.  A method of producing a circuit board, comprising:

    a step of removing a temporary substrate from a circuit that is formed on the temporary substrate, and
    a step of disposing the circuit on an insulating layer, in such a manner that a side of the circuit that faced the temporary substrate faces the insulating layer.

2.  The method of producing a circuit board according to claim 1, wherein the circuit is formed by removing a bridge from a metallic member that is disposed on the temporary substrate and that comprises a circuit portion and the bridge.

3.  The method of producing a circuit board according to claim 1 or 2, further comprising a step of filling, with a resin, a space between circuits formed on the temporary substrate.

4.  The method of producing a circuit board according to any one of claims 1 to 3, wherein a thickness of the circuit is 350 $\mu$m or greater.

5.  The method of producing a circuit board according to any one of claims 1 to 4, wherein a thickness of the insulating layer is smaller than a thickness of the circuit.

6.  A circuit board, comprising:

    an insulating layer; and
    a circuit disposed on the insulating layer,
    wherein a thickness of the circuit is 350 $\mu$m or greater.

7.  The circuit board according to claim 6, further comprising a resin with which a space between circuits is filed.

8.  The circuit board according to claim 6 or 7, wherein a thickness of the insulating layer is less than a thickness of the circuit.

FIG. 1

FIG. 2

## FIG. 3

1

10

## FIG. 4

1

10

FIG. 5

FIG. 6

FIG. 7

FIG. 8

FIG. 9

FIG. 10

## INTERNATIONAL SEARCH REPORT

| International application No. |
| --- |
| PCT/JP2016/085937 |

**A. CLASSIFICATION OF SUBJECT MATTER**
*H05K3/20*(2006.01)i, *H01L23/50*(2006.01)i, *H05K1/02*(2006.01)i, *H05K3/28*(2006.01)i

According to International Patent Classification (IPC) or to both national classification and IPC

**B. FIELDS SEARCHED**

Minimum documentation searched (classification system followed by classification symbols)
H05K3/20, H01L23/50, H05K1/02, H05K3/28

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2017 |
| Kokai Jitsuyo Shinan Koho | 1971–2017 | Toroku Jitsuyo Shinan Koho | 1994–2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | JP 7-086704 A (Matsushita Electric Industrial Co., Ltd.),<br>31 March 1995 (31.03.1995),<br>paragraphs [0009] to [0011]; fig. 1, 2<br>(Family: none) | 6,8<br>1-8 |
| Y | WO 2009/110376 A1 (Mitsubishi Electric Corp.),<br>11 September 2009 (11.09.2009),<br>paragraphs [0010] to [0012], [0016] to [0017],<br>[0021] to [0022], [0028]<br>& TW 200941684 A | 1-8 |
| A | JP 6-216499 A (Toshiba Corp.),<br>05 August 1994 (05.08.1994),<br>paragraphs [0025] to [0032]<br>(Family: none) | 1-8 |

| ☒ Further documents are listed in the continuation of Box C. | ☐ See patent family annex. |
| --- | --- |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>07 February 2017 (07.02.17) | Date of mailing of the international search report<br>21 February 2017 (21.02.17) |
| --- | --- |
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2016/085937

C (Continuation). DOCUMENTS CONSIDERED TO BE RELEVANT

| Category* | Citation of document, with indication, where appropriate, of the relevant passages | Relevant to claim No. |
|---|---|---|
| A | US 2014/0262439 A1 (GM GLOBAL TECHNOLOGY OPERATIONS LLC), 18 September 2014 (18.09.2014), paragraphs [0013] to [0017] & DE 102014102581 A & CN 104051925 A | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001036201 A